# EUROPEAN PATENT SPECIFICATION

(11) **EP 1 116 269 B1**
(45) Date of publication and mention of the grant of the patent: **31.12.2008**
(21) Application number: 99945182.6
(22) Date of filing: 23.08.1999
(51) Int. Cl.: H01L 21/8238, H01L 21/205, H01L 21/8228, H01L 21/8249

(54) **COMPLEMENTARY BIPOLAR/CMOS EPITAXIAL STRUCTURE AND PROCESS**
KOMPLEMENTÄRE EPITAKTISCHE BIPOLAR/CMOS STRUKTUR UND VERFAHREN
PROCEDE ET STRUCTURE EPITAXIALE COMPLEMENTAIRE BIPOLAIRE/CMOS

(30) Priority: 08.09.1998 US 149353
(43) Date of publication of application: 18.07.2001
(73) Proprietor: Burr-Brown Corporation, Tucson Arizona 85706 (US)
(72) Inventor: DROBNY, Vladimir, F., Tucson, AZ 85750 (US); BAO, Kevin, X., Tucson, AZ 85715 (US)
(74) Representative: Degwert, Hartmut
(86) International application number: PCT/US1999/019370
(87) International publication number: WO 2000/014795

(56) References cited:
- EP-A- 0 501 316
- US-A- 3 956 037
- US-A- 4 153 486
- US-A- 4 368 098
- US-A- 5 256 887
- US-A- 5 324 226
- US-A- 5 329 150
- US-A- 5 378 651
- US-A- 5 691 226
- US-A- 5 777 364

## Description

### CROSS REFERENCE TO RELATED APPLICATION

This application claims the benefit of prior filed co-pending U. S. Provisional Application Serial No. 60/073,883, filed February 6, 1998, entitled "ENGINEERED EPI FOR HIGH SPEED CBCMOS TECHNOLOGY" by Vladimir F. Drobny and Kevin Bao.

### BACKGROUND OF THE INVENTION

The invention relates to a high speed complementary bipolar/CMOS process that provides a doping profile in the collectors of NPN transistors formed in an epitaxial layer so as to avoid a "dip" in N type dopant concentration, which dip causes slow speed and other undesirable properties of the NPN transistors.

Those skilled in the art know that it is difficult to provide a process for manufacturing an epitaxial silicon layer that is satisfactory for use in a high speed complementary bipolar/CMOS process. In such a process a very thin, lightly doped N type epitaxial silicon layer must be grown on a silicon wafer including pre-formed P+ boron doped buried layers and N+ arsenic doped buried layers formed in a P- substrate. In a typical prior art complementary bipolar/CMOS process the epitaxial layer is doped lightly in situ with arsenic to concentration of approximately 2×10¹⁵ cm⁻³ to achieve optimal characteristics of NPN, PNP and CMOS transistors to be formed. After the epitaxial deposition, the collector regions of the PNP and NPN transistors and the CMOS "wells" are further doped by a combination of low energy and high energy boron or phosphorous implants, with energies and doses tailored to the needs of various "families" of devices. During conventional epitaxial growth and subsequent conventional thermal processing, both the P type buried layers and the N type buried layers updiffuse into the epitaxial layer. That reduces the thickness of the useful portions of the collector regions for the transistors being fabricated. Since the P+ and N+ buried layers diffuse at significantly different rates, the PNP transistors end up having shallower collectors than the NPN transistor.

Since the diffusion of a P+ buried layer accelerates more rapidly than an N+ layer with respect to temperature, differences in the thicknesses of the collectors of the PNP transistors and the NPN transistors can be minimized by keeping the "Dt" of all high temperature process steps as low as possible. ("Dt" is a term referring to the cumulative amount of time that the wafer is subjected to high temperatures, usually exceeding 1000°C, after the epitaxial layer has been deposited.) The deep double implants used to form the collectors of the required depth for the NPN and PNP transistors, respectively, eliminate the need for high Dt diffusions after the formation of the epitaxial layer.

Note that a drawback associated with the large differential dopant diffusivity of arsenic buried layers and boron buried layers remains even for "low Dt processing". For very low Dt processes, achieving the desirable PNP collector often results in producing an undesirable lightly doped N type subregion where an NPN collector region meets the N+ buried layer.

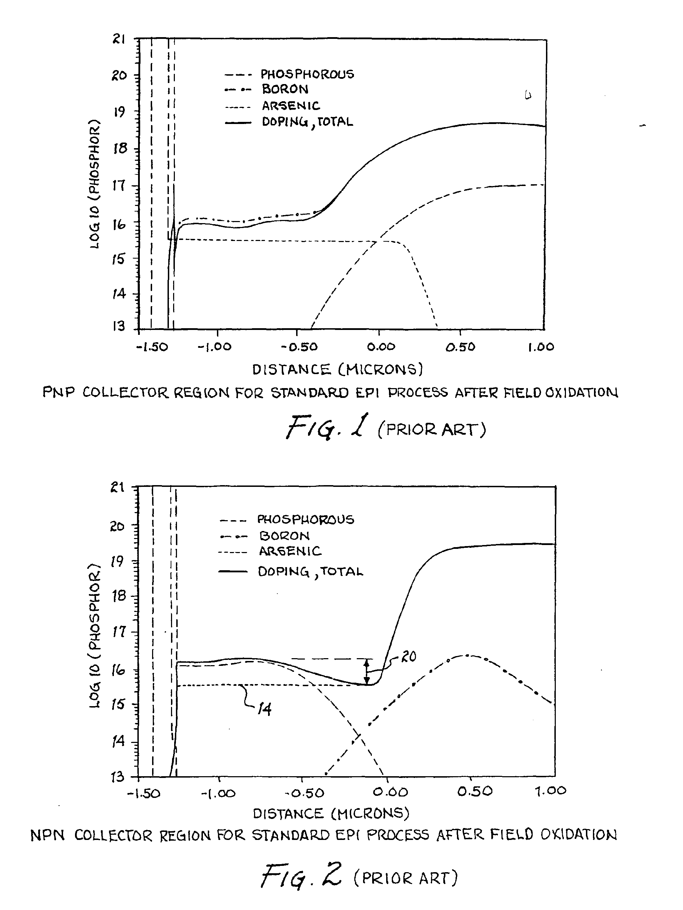

Furthermore, the value of N- dopant in the epitaxial layer must be selected to achieve the best characteristics of both the PNP and NPN transistors. If the N- concentration is as high as would be desirable for the NPN collector regions, then it would be far too high for the PNP transistors. Therefore, a lower N- epitaxial dopant level, indicated by numeral 14 in Fig. 2, is selected instead. Then an N type ion implantation is applied to the surface, raising the N type dopant concentration to a suitable level for the NPN collectors. Unfortunately, it is impractical to provide the dose and energies needed to produce the "flat" N type epitaxial dopant concentration profile at the bottoms of the NPN collector regions. Consequently, the failure of the implanted ions to reach the bottoms of the NPN collector regions is a partial cause of the "dip" 20 in Fig. 2.

The problem of such light doping is further aggravated by boron autodoping, wherein a large number of P type boron atoms escape from the large P+ buried layer area and then diffuse into the surface of the P- substrate and into the lightly doped N type epitaxial layer being grown, reducing or "compensating" its dopant concentration. This results in increased collector resistance and corresponding increased V_{CE(sat)} voltage, reduced f_{T} (i.e., the unity gain frequency or cutoff frequency), lower NPN switching speeds, and higher power dissipation.

Figs. 1 and 2 show typical dopant concentration profiles for the PNP and NPN collector regions, respectively, made by a conventional complementary bipolar process after completion of a field oxidation step, during which most of the dopant diffusion occurs.

The dopant profiles of Figs. 1 and 2 were obtained from a simulation of the dopant diffusions for the conventional epitaxial deposition process. The process simulation was calibrated to match experimental results measured from a substrate with a large percentage (for example 80%) of the wafer surface area implanted with a dose of approximately 1×10¹⁵ cm⁻² of boron followed by a P+ buried layer diffusion. (As those skilled in the art will recognize, the reason the large percentage of the P+ wafer substrate area has P+ "buried layer material" therein is to reduce substrate resistance and increase latch-up immunity of bipolar transistors and CMOS transistors.)

The prior art epitaxial process referred to above includes a high temperature H₂ pre-bake followed by a high temperature purge and then by a 1.5 micron deposition of an epitaxial layer of lightly arsenic doped single crystal silicon. The large amount of P+ surface area of the substrate causes a large amount of boron auto-doping into the lightly doped N type epitaxial layer being formed. The amount of corresponding boron autodoping in the dopant concentration profile of prior art Figs. 1 and 2 was computed using simulated TSUPREM-4 profiles, and the simulated profiles were calibrated to match the measured experimental results. The TSUPREM-4 simulation program is a commercially available software package "Two-dimensional Process Simulation Program", sold by Avant! Corporation, formerly Technology Modeling Associates.

For thin epitaxial layers (e.g., less than two microns in thickness), the autodoping strongly influences the transistor collector dopant concentration profiles. The large P+ substrate surface area mentioned above contributes a significant amount of boron autodoping during the epitaxial growth, which aggravates the above-mentioned problems with the performance of the NPN transistors, further reduces the depth of the PNP collector regions, and increases the difference between the breakdown characteristics of NPN and PNP transistors. The standard flat dopant profile epitaxial process techniques used to generate the profiles in prior art Figs. 1 and 2 are not able to correct these problems.

Referring to Figs. 1 and 2, the dopant concentration profiles of the prior art NPN and PNP collector regions are noticeably different when a standard epitaxial process is used. The differences between the peak implant concentration depths (commonly referred to as Rp) for phosphorus and boron implants is another cause of the large difference in the dopant concentration profiles of the NPN and PNP collector regions when practical implant energies are used. This difference is further aggravated by the boron autodoping. The NPN collector region, doped by a combination of low and high energy implants, shows a significant dopant concentration dip at its bottom, indicated by reference arrows 20 in Fig. 1. This very lightly doped region adversely affects both the AC and DC performance of the NPN transistor by raising its collector region resistivity. This increases its collector resistance and thereby reduces f_{T} and increases the collector-to-emitter saturation voltages of the NPN transistor.

Prior experimentation in forming arsenic doped N+ epitaxial caps in the hope of increasing the doping concentration at the bottoms of the NPN collector regions has failed to adequately compensate for the boron autodoping at the epitaxial/substrate interface.

Thus, there is a need for an improved epitaxial process for complementary bipolar/CMOS for providing bipolar transistors, especially NPN transistors, with more ideal collector profiles leading to lower collector resistances and higher values of f_{T} than has been previously achievable.

### SUMMARY OF THE INVENTION

Accordingly, it is an object of the invention to provide a high speed complementary bipolar/CMOS epitaxial process that provides NPN transistors in which undesirable effects of a dip or decrease in the N type collector dopant concentration profile close to an N+ buried layer are avoided.

It is another object of the invention to provide a high speed complementary bipolar/CMOS epitaxial process in which the NPN and PNP transistors have similar performance characteristics.

It is another object of the invention to provide a high speed complementary bipolar/CMOS process in which the NPN transistors have higher f_{T}, lower collector resistance, and lower collector-to-emitter saturation voltage than has been previously achievable.

It is another object of the invention to provide a high speed complementary bipolar/CMOS process with a very uniform collector dopant concentration profile which leads to a high cutoff frequency f_{T} that is higher than previously has been achieved.

It is another object of the invention to provide a high speed complementary bipolar/CMOS process wherein process techniques that allow eliminating an undesirable dip in the dopant concentration profile of the collectors of the NPN transistors also allow optimization of the dopant concentration profile of the collectors of the PNP transistors.

Briefly described, and in accordance with one embodiment thereof, the invention provides a method of making an epitaxial layer on a P type silicon substrate having a P+ field layer region in most of a major surface of the substrate. The method includes loading the substrate in a reactor with a carrier gas therein, pre-baking the substrate, further heating the substrate, providing N+ dopant gas with the carrier gas, deoxidizing the substrate in the presence of the N+ dopant gas, depositing a first intrinsic epitaxial cap layer, performing a first bake cycle, depositing a second intrinsic epitaxial cap layer, performing a second bake cycle, and depositing an N- epitaxial layer having a thickness substantially greater than the thickness of either of the first and second cap layers. The process avoids an undesirable dip in the dopant concentration profile of the collector of PNP transistors formed in the epitaxial layer and results in higher f_{T}, lower V_{SAT} devices. The invention provides a semiconductor structure according to independent claim 10.

### BRIEF DESCRIPTION OF THE DRAWINGS

Fig. 1 is a doping profile of the collector region of a PNP transistor for a standard prior art epitaxial process.
Fig. 2 is a doping profile of the collector region of an NPN transistor fabricated using the standard prior art epitaxial process.
Fig. 3 is a flow chart useful in describing the process of the present invention.
Fig. 4 is a doping profile of the collector region of an NPN transistor formed using the process of the present invention.
Fig. 5 is a doping profile of the collector region of a PNP transistor formed in an epitaxial region grown using the process of the present invention.
Fig. 6 is a plan view of a wafer showing locations of P+ and N+ buried layer regions and the deep N+ regions.
Fig. 7 is a partial section view of a wafer illustrating the structure of a chip manufactured using the complementary bipolar/CMOS process of the present invention.
Fig. 8 is a partial section view of the wafer shown in Fig. 7 after deposition of the two intrinsic epi layers and a lightly doped N type epi layer in accordance with the invention.

### DETAILED DESCRIPTION OF THE PREFERRED EMBODIMENTS

In accordance with the present invention, numerous experiments have been performed to evaluate effects of the durations and temperatures of pre-bake cycles and HCl cycles on the amount of released or "escaped" boron dopant atoms from the P+ regions in an P- substrate and the resulting P type autodoping of adjacent regions of the wafer. Intrinsic epitaxial "cap" layers and arsenic doped epitaxial cap layers were evaluated for their ability to reduce or suppress the P type autodoping and to increase the N type dopant concentration near the bottom of the NPN collectors. Low temperature purges and high temperature purges were evaluated with respect to their effectiveness in reducing the concentration of the undesired P type dopant during the epitaxial deposition.

As a result, the epitaxial growth cycle technique of the present invention was developed and was shown to reduce the amount of the previously mentioned "dip" 20 (Fig. 2) in the NPN collector doping profile by selectively providing N type dopant ions at depths deeper than achieved during an N type implantation process, and also suppress the P type autodoping. The technique developed introduces dopant during the H₂ high temperature bake cycle. That is followed by deposition of an intrinsic epitaxial cap layer, followed by a high temperature gas purging cycle. This technique proved to be the most effective in reducing the amount of autodoping and correcting the above mentioned dip in the NPN collector profile doping to thereby provide the desired NPN collector dopant concentration profile.

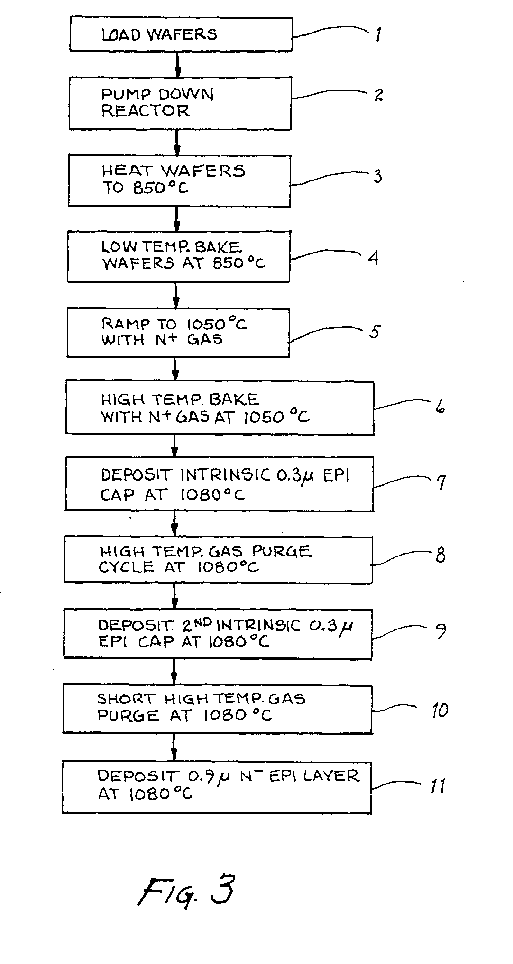

The basic epitaxial growth cycle of the present invention introduces an N type dopant (arsenic) into the H₂ high temperature bake cycle. Then an intrinsic epitaxial layer cap is deposited, followed with a high temperature purge and then completed with the final arsenic doped epitaxial layer deposition. This basic process suppresses the boron autodoping and at the same time tends to correct the NPN collector doping profile. The introduction of the N type dopant during the H₂ high temperature bake cycle proved to be very effective in correction of the NPN collector profile, as shown in Fig. 3, wherein the substantial dip 20 of prior art Fig. 1 has been corrected.

The process offers very good control over the dopant level at the bottom of the NPN collector. The epitaxial high temperature bake cycle of the present invention improves the NPN collector N type dopant concentration profile; this occurs without adversely affecting the P type dopant concentration profile of the PNP collectors. The described process also has a benefit in improving the PNP collector profile, especially when heavier N type compensation is required.

In the process flow chart of Fig. 3, blocks 1-4 of the illustrated process refer to conventional steps for growth of a lightly doped N type epitaxial silicon layer on a lightly doped P type silicon substrate. The low temperature step of block 4 is performed at 850°C for roughly 10 minutes, including ramp-up. Steps 5-11 of Fig. 3 are performed at high temperatures in the presence of hydrogen which is used as a carrier gas.

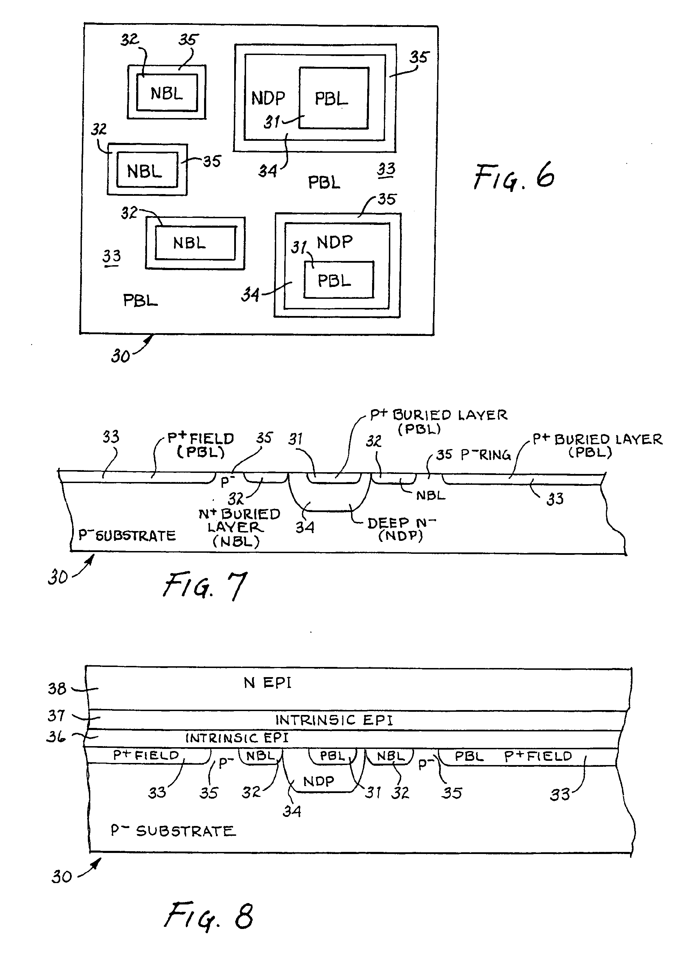

Referring to Figs. 3 and 6, note that the wafers referred to in block 1 include the numerous P+ buried layers 31 for the collectors of PNP transistors to be formed, N+ buried layers 32 of NPN transistors to be formed, and the "field" P+ region 33 such that the large (e.g., approximately 80%) of the surface area of each wafer contains a heavy concentration of P+ (boron) dopant atoms. Fig. 6 shows a single chip 30 of one of the silicon wafers. A number of P+ buried layers 31 and N+ buried layers 32 are formed in the P- substrate, as shown. An N+ "ring" 32 around each N- well 34 and P+ buried layer 31 therein as it appears in Fig. 6 is formed by a "deep N+" regions 34 in which the P+ buried layer is found. Each of the layers 32 and 34 is surrounded by a "ring" 35 of P- substrate material between that layer and the P+ layer 33.

Fig. 7 shows a cross sectional area of a portion of the wafer 30 before the beginning of the process of Fig. 3. Deep N- regions 34 and P- rings 35 separate and electrically isolate each P+ buried layer 31 from the rest of the P+ layer 33 of chip 30, which includes diffused P+ material identical to that of the P+ buried layers 31.

That means that when the wafers are raised to the processing temperatures of 1060°C to 1080°C shown in Fig. 3, many boron atoms escape from the large P+ surface area 33 of the wafer into the H₂ carrier gas and then act as a P+ dopant gas so as to "auto-dope" the N type epitaxial layer being grown, unless something is done to prevent that from occurring. If not for the present invention, the decreased dip in the collector dopant concentration profiles would increase the resistivities of the collector regions of the NPN transistors subsequently formed over the N+ buried layer regions, making them slower and causing the other above mentioned performance degradation.

The combination of steps indicated in blocks 5-9 of Fig. 3 is new in an epitaxial silicon growth process. Specifically, the step of block 5, to include N+ type dopant (arsenic) molecules in the H₂ carrier gas during such a heating step in an epitaxial growth process is novel, and is necessary to counteract the escaped "P+" boron atoms involved in the autodoping.

Although it is conventional to perform the high temperature bake step of a prior art epitaxial silicon growth process in the presence of hydrogen at high temperature, it is novel to include N+ dopant molecules in the hydrogen carrier gas during such high temperature bake step as indicated in block 6. This high temperature bake step is performed at 1050°C for two minutes. In block 5 and 6 the amount of N+ dopant gas injected is approximately 280 sccm (standard cubic centimeters per minute) in a total H₂ flow of 280 slm (standard liters per minute).

As indicated in block 7 of Fig. 3, a very thin 0.3 µm (micron) layer or "cap" layer 36 of intrinsic, i.e., undoped, epitaxial silicon, shown in Fig. 8, is deposited over the entire surface of the wafer to form a "seal" or cap over the large percentage of the wafer which has P+ "field" diffusion and P+ buried layers therein. This intrinsic "carp" layer 36 prevents the above mentioned P+ boron atoms from escaping from the large P+ area into the hydrogen carrier gas. Intrinsic cap layer 36 also inhibits P+ boron atoms in the carrier gas form entering the N+ buried layers 32. Thus, the intrinsic cap layer 36 inhibits above mentioned P type "auto-doping" that reduces N type dopant concentration in the collectors of the subsequently formed NPN transistors and reduces their operating speeds.

Block 8 refers to a high temperature gas purge cycle at 1080°C for approximately 5-10 minutes, depending on the ratio of P+ field area 33 to the total wafer area to cause redistribution of the dopant molecules in the wafer in accordance with the above mentioned ratio of the P+ field diffusion area to the "non-P+" area. The high temperature gas purge cycle of block 8 also causes outgassing of arsenic molecules previously diffused during the high temperature bake cycle of blocks 5 and 6 into the susceptor (on which the substrates are supported) and into other surfaces of the inside of the reactor. The high temperature gas purge cycle of block 8 prevents these outgassed N type dopant molecules from doping the next intrinsic cap layer 37, shown in Fig. 8, deposited according to block 9 of Fig. 3, and was found to be necessary to achieve the desired NPN collector dopant concentration profile without a substantial dip 20 (Fig. 2).

The second high temperature gas purge cycle at 1080° C indicated in block 10 is not nearly as critical as the first high temperature gas purge cycle of block 8, because the first high temperature gas purge cycle eliminates a majority of the dopant molecules that otherwise would enter the carrier gas from the various inner surfaces of the reactor and susceptor and then reenter the wafer surface and therefore affect the dopant concentration profiles of the NPN and PNP transistors.

The main reason for depositing the second intrinsic cap layer 37 according to block 9 is to provide a "sharper" transition in the dopant concentration profile than would be achieved if only a single intrinsic cap layer were provided. The elimination of the undesired autodoping species by the first high temperature gas purge cycle of block 8 is what makes it possible for the second intrinsic cap layer 37 to continue the initial sharp transition that would be made into a more gradual transition if the extraneous dopant species from the inner surfaces of the reactor were not first removed.

Block 9 of Fig. 3 illustrates the growth of the above-mentioned second intrinsic 0.3 micron cap layer 37 of undoped epitaxial silicon at 1080°C on top of the first 0.3 micron intrinsic layer 36 grown in step 7. Second cap layer 37 further helps to prevent undesired P type and N type auto-doping. Then, after a short, high temperature bake process at 1080°C for 1 minute as indicated in block 10, a conventional 0.9 micron N- epitaxial deposition of silicon layer 38, shown in Fig. 8, is formed on the top of the second intrinsic cap at 1080° C, as indicated in block 11. The total thickness of the composite epitaxial silicon layer 36,37,38 formed on the wafer substrate therefore is 0.3 + 0.3 + 0.9 = 1.5 microns.

In accordance with the present invention, the presence of the N+ dopant during the steps of blocks 5 and 6 provides enough N+ atoms which, during the growth of the first and second intrinsic epitaxial layers 36 and 37, respectively, of Fig. 8 provides a graded increase in the N type concentration at the bottoms of the NPN collector regions to compensate for a decrease in N type concentration in the region which the implanted N type dopant ions failed to reach. This reduces the collector resistance, increasing the cutoff frequency f_{T}.

It should be appreciated that those skilled in the art know that even if the ratio of area of P+ "field" diffusion and P+ buried layer area on the surface of a wafer to the total area of the wafer amount both the P+ is substantially less than the 80% ratio in the above described example, a serious P+ autodoping problem nevertheless will exist and need to be compensated according to the present invention. If a higher number or "density" of transistors in the wafer surface is increased, the ratio of the P+ "field" area 33 to the total wafer area may decrease to values far lower than 80%. Nevertheless, a sufficient number of P+ atoms may escape and cause autodoping that, without the present invention, result in a significant dip in the N type dopant concentration profile at the "bottoms" of the NPN collector regions. Therefore, the high temperature bake cycle in the presence of N+ dopant to compensate such P+ autodoping and at least one, and preferably two, intrinsic epi cap layers will suppress the P- autodoping as described herein.

Note that the high temperature gas purge cycle of block 8 can be used to "fine tune" the shape of the N type dopant concentration profile for the NPN transistors as a function of the above-mentioned ratio of the P+ "field" diffusion area 33 to the total area of the wafer surface in which the integrated circuit is formed by adjusting the duration and temperature of the temperature of that high temperature bake cycle.

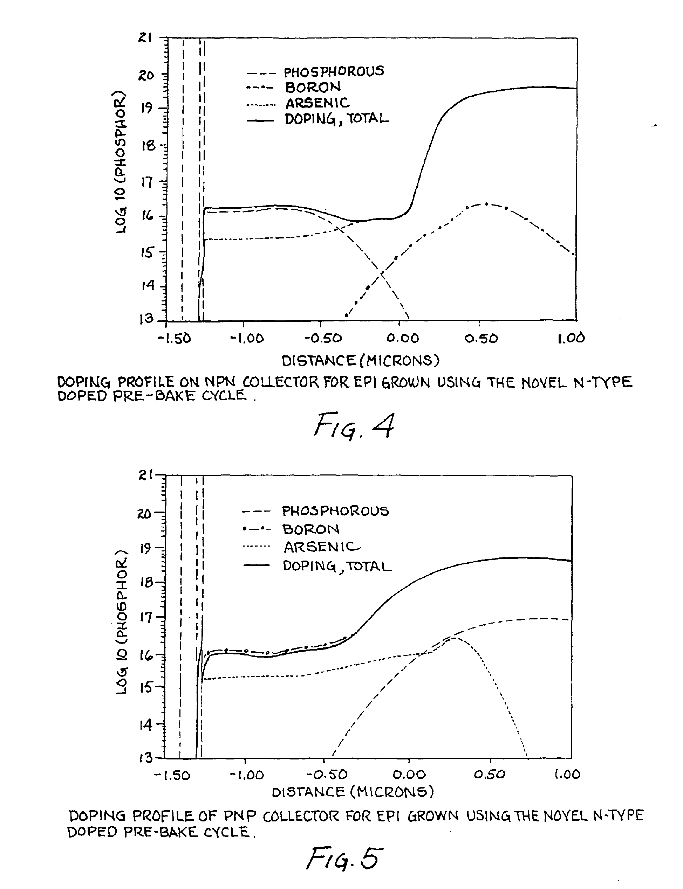

As a result of the foregoing process, doping profiles shown in Fig. 4 for the collectors of NPN transistors formed in the 1.5 micron epitaxial layer are achieved. This doping profile avoids the "dip" 20 in the N type dopant concentration shown in prior art Fig. 2 representing the previously described undesirably low concentration of N type impurities at the bottoms of the NPN collector regions.

Thus, the invention provides an epitaxial process engineered specifically to (1) reduce the boron autodoping effect and (2) correct the differences in profiles of the PNP and NPN collector regions. Thin, intrinsic epitaxial layers are formed on a lightly doped P type silicon substrate having a large percentage of its surface area occupied by P+ regions, and a smaller percentage by N+ regions, for the purpose of preventing outgassing of P type impurity atoms during growth of an epitaxial N- layer and preventing such P type atoms from auto-doping the bottom portions of the N- Epitaxial layers above N+ buried layer regions formed in the substrate.

By way of definition, the term "intrinsicly-formed" is used to refer to an epitaxial layer that is formed without dopant being introduced from an external or outside source into the reactant gas, even though dopant impurities are formed in the "intrinsicly-formed" epitaxial layers because such dopant impurities are introduced into the reactant gas from ambient internal sources. Such ambient internal sources include autodoping from heavily doped regions formed earlier in the substrate and also include N+ atoms introduced into surfaces of the system earlier during the temperature ramp up of block 5 of Fig. 3 in the presence of N+ gas and the high temperature bake of block 6 of Fig. 3 in the presence of N+ gas.

Appendix 1, attached hereto and incorporated herein, is a copy of a related unpublished paper by the inventors to be publicly presented by the inventors approximately September 20, 1998.

In appendix 1, only section 6.3 entitled "Dual intrinsic cap process" describes an embodiment of the invention.

### APPENDIX 1

### Novel Thin Epi Process for High Speed CB-CMOS

### Vladimir F. Drobny and Kevin X. Bao

### Technology Development, Burr-Brown Corporation 6730 S. Tucson Blvd. M/S #322, Tucson, AZ 85706 drobny_vladimir@burr-brown.com

### ABSTRACT

Matching NPN and PNP collector profiles for high-speed complementary bipolar technology presents a special challenge to epi processing. This paper describes a novel thin epi process that is designed to reduce the effect of boron autodoping and improve the NPN collector doping in the deep portion of the collector region. Summary evaluations of autodoping are presented for different H₂ bake and HCl etch cycles, and for the use of intrinsic- and As-doped cap layers. An epitaxial technique, which introduces As dopant during the high temperature H₂ bake, is described. This technique has proven very effective in suppressing the effects of boron autodoping and correcting the NPN collector profile.

Keywords: Epitaxial growth, Complementary Bipolar Process, CMOS, autodoping, boron, arsenic

### 1. INTRODUCTION

High-speed Complementary Bipolar (CB)/CMOS technology requires thin epi deposited over a wafer with boron- and arsenic-doped buried layers. During processing, the buried layers diffuse into epi and reduce the thickness of collector regions. The fast diffusing P⁺ buried layer limits the maximum Dt the process can use before PNP collector becomes too shallow. Optimizing a CB process always requires a delicate balancing of the buried layer-collector profiles ofNPN and PNP transistors. The 12V CB/CMOS process architecture assumed in this paper requires an epitaxial layer that is 1.5 µm thick. The collector regions and CMOS wells are formed by a combination of shallow and deep implants into a lightly-doped epi layer. Figure 2 shows a TSUPREM4^{™} (TS4) simulated profile of the NPN E-C region for an epitaxial process with a flat profile. If (due to equipment limitations) the maximum implant energy of 175 keV is used to implant P⁺⁺ species, then achieving the desirable PNP collector by very low Dt processes results in a concentration dip where the collector meets the N⁺ buried layer. Figure 1 shows TSUPREM4™ (TS4) simulated profile of the PNP E-C region for a flat profile epitaxial process. The difficulty of matching NPN and PNP collector profiles is aggravated by severe boron autodoping from a large 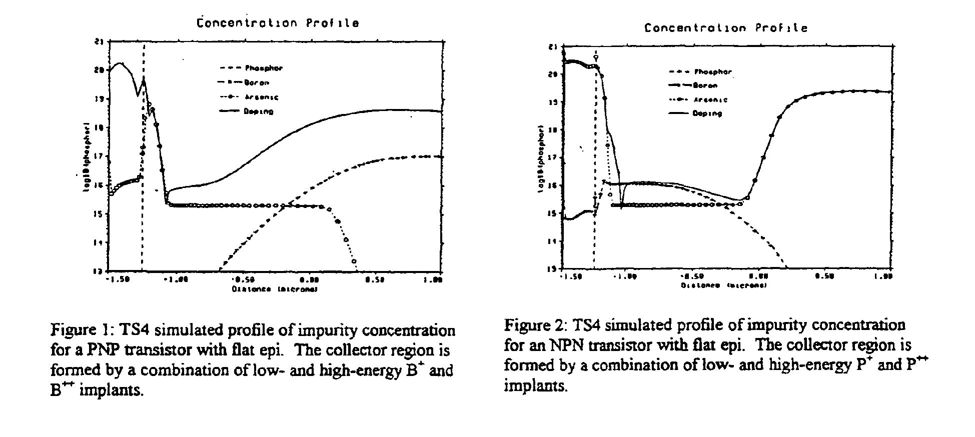 P⁺ area covering >80% of the chip. In the case of a thin epi, the boron autodoping also severely degrades the device isolation region. The standard epi process, with its flat doping profile, is not able to address either of these problems. For an illustration of one such problem, refer to Figure 3. Figure 3 shows an undesired p/n junction formation in the TSUPREM-4 simulated doping profile of the NPN collector region in the presence of boron autodoping. In the vicinity of buried layer, the boron completely overdopes the N-type collector region. The simulator was set up to match the simulated autodoping with the experimental results from the standard epi process (see Figure 6).

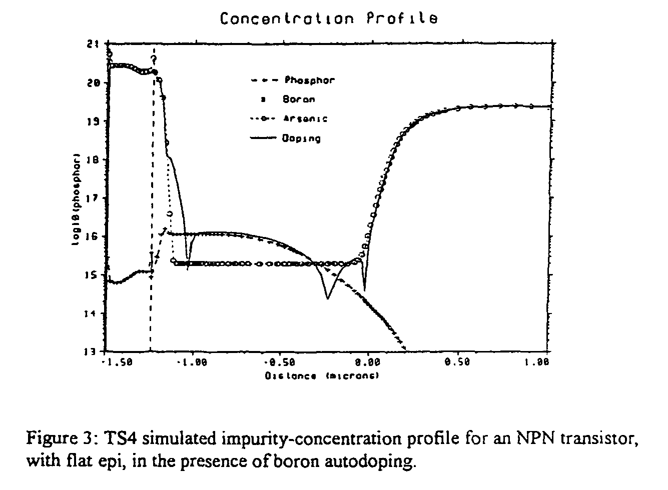

To improve the NPN collector profile, we need to reduce the level of boron autodoping, compensate for the boron autodopant by N-type species, and elevate the collector concentration in the vicinity of buried layer using a graded concentration epitaxial layer. Figure 4 shows a doping profile of a PNP with a graded epi layer. Figure 5 shows the same for the NPN. The NPN transistor shows great improvement in collector doping without degradation of the PNP profile.

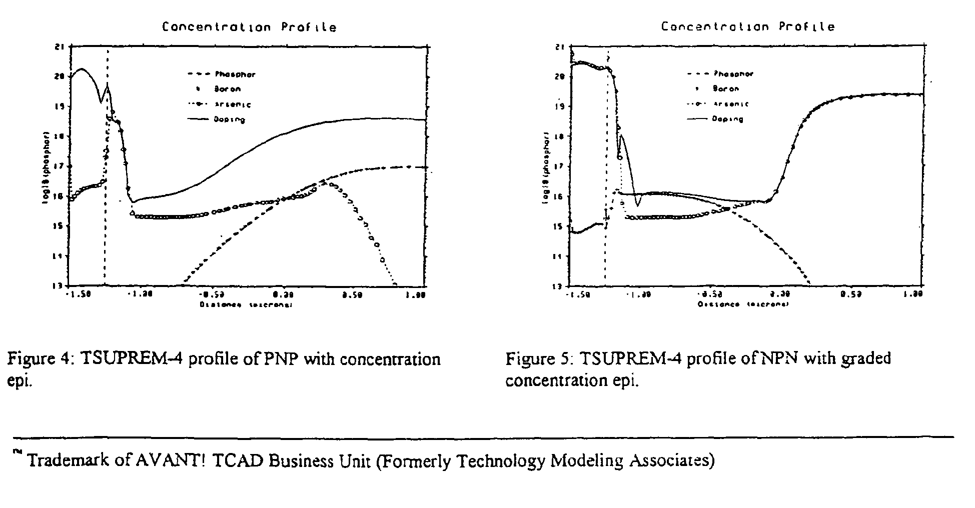

In Figure 7 the profile labeled P#1shows the concentration profile for an arsenic-doped epi layer grown using the standard process. The standard process (P#1) uses a 10 minute H₂ bake at 1180°C, followed by a 2 minute HCl etch at 1180°C, a 2 minute H₂ gas purge at 1180°C, and the growth of a 1.5 µm thick arsenic-doped epitaxial layer at 1100°C. According to TSUPREM-4 simulations, the total boron dose of 1x10¹³ cm⁻² was incorporated into the substrate by autodoping during the period beginning with the H₂ bake cycle and continuing until the start of the epitaxial growth. Simulations also include the effects of additional autodopant that was incorporated into the epi layer during the initial portion of its growth cycle.

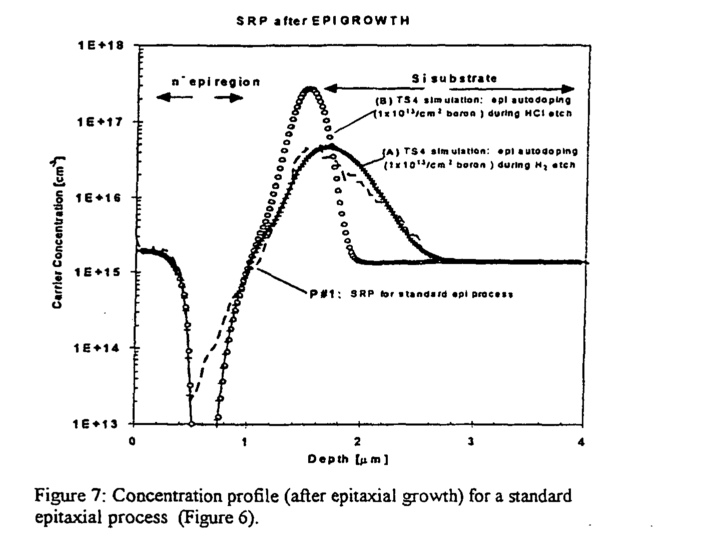

Two TSUPREM-4 simulated SRP profiles have been added to Figure 7 to further our understanding of just when the major autodoping occurs. The SRP profiles were simulated under two different assumptions regarding the autodoping origin, i.e. (A) boron evaporated during the H₂ bake cycle and (B) boron released during the HCl etch cycle. The pre-epi growth autodoping effect was simulated by implanting B₁₁⁺ at 10 keV into silicon at points (A) or (B) of the epi cycle, as shown in Figure 6. In both cases, the simulations also include effects of autodoping during the actual epi growth cycle. The SRP curve simulated under assumption (A) matches the measured SRP quite well. The shallow SRP profile (B) indicates there is not enough Dt for the implanted boron to reach the measured SRP profile depth. Based on these results, we can conclude that the majority of autodoping occurs during the H₂ bake cycle. Similar observations were made by Shrinivasan¹ and other authors.

### 4. EFFECTS OF H₂ BAKE

### 4.1 Effect of H₂ bake temperature

The high temperature H₂ bake cycle is used to remove the native silicon dioxide before beginning the epi growth step. As shown above, this cycle evaporates a significant amount of boron from the buried layer into the epi reactor ambient, which provides the source for autodoping. It is known that boron autodoping increases with temperature and decreases with deposition rate². It is also expected that autodoping increases with the amount of time that the silicon wafer is exposed to autodopant. Lowering the H₂ bake temperature and duration offers a convenient adjusting control for reducing the effect of boron autodoping. To confirm our believe that the H₂ bake dominates the autodoping, we used two etch times of I and 2 minutes at 1150°C to evaluate the change in magnitude of the HCl etch contribution to autodoping. The HCl etch was

This paper describes a technique for epi deposition that is designed to reduce the effects of boron autodoping and correct the dip in the NPN collector profile. Summary evaluations of autodoping are presented for different pre-bake and HCl cycles, low- and high-temperature purges, and for using intrinsic and **N⁺** (As) doped cap layers. It is demonstrated that an N⁺ epi cap can correct the deep collector profile, but that it fails to compensate adequately for boron autodoping at the epi/substrate interface. A novel epitaxial deposition technique that introduces an N-type dopant during the H₂ bake cycle was developed. The H₂ bake is followed by an intrinsic epitaxial cap deposition, a high temperature gas purge, and the final As-doped epitaxial deposition. The pre-epi deposition steps are designed to suppress the autodoping effect and correct the NPN collector doping profile. Introducing the dopant during the H₂ pre-bake cycle is an effective way to correct the NPN collector profile. This new process offers very good control over the dopant level at the bottom of the NPN collector, without any negative impact on the profile of the PNP collector.

### 2. EXPERIMENTS AND SIMULATIONS

All of the experimental work described in this paper was performed on an Applied Materials 7810 batch reactor with an eight-sided susceptor operating at 80 Torr in the reduced pressure mode. The process gas we used was dichlorosilane and the dopant gas was 100 ppm arsine in hydrogen. Unless noted otherwise, the susceptor was always fully filled with wafers that had approximately 90% P⁺ buried layer coverage and the measured wafers occupied the middle row of the susceptor. SOLECON Laboratories performed the SRP measurements and IBM Analytical Services provided the SIMS data. A Nicolet FTIR was used to measure the thickness of the epi. The quality of the epi was monitored using a LEICA optical microscope in the Nomarski mode of operation. A TSUPREM-4 process simulator was used to simulate the impurity and SRP profiles. When TSUPREM-4 profiles were plotted as SRP profiles, it is so stated. In all other cases, the simulated data represent the actual impurity profiles.

### 3. STANDARD EPI PROCESS RESULTS

The standard epitaxial process cycle is graphically represented in Figure 6. 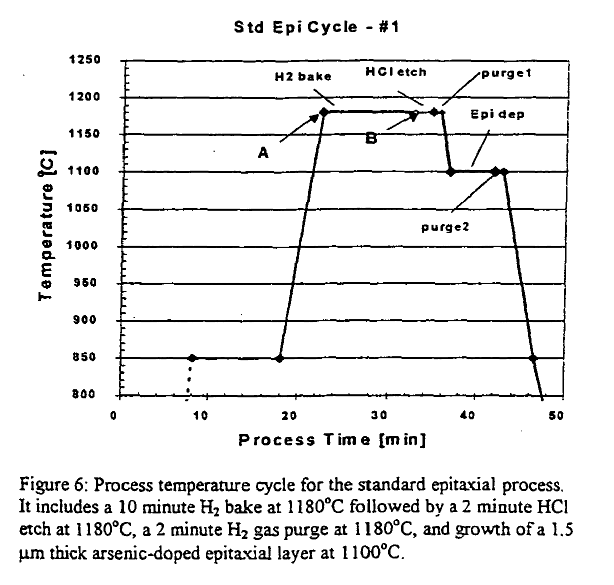 preceded by only a 1 minute short H₂ bake at 1150°C to minimize its effect. Figure 8 shows that autodoping remains about the same for I and 2 min HCl etches. This proves that HCl has minimal effect on the magnitude of autodoping.

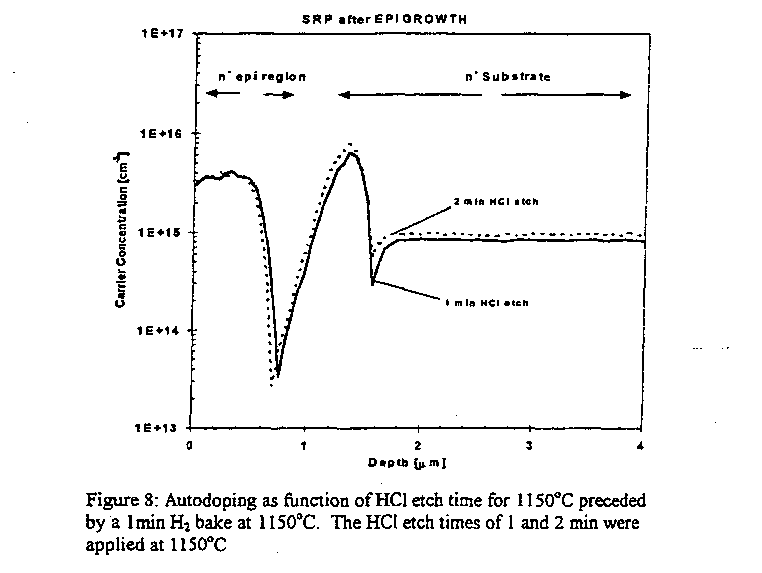

Figure 9 shows SRP profiles for the standard epi process (P#1) and the low temperature H₂ bake processes (P#2). The process P#2 employs a 1 minute H₂ bake at 1150°C and a 2 minute HCl etch at 1150°C. The standard process P#1 uses a 10 minute H₂ bake at 1180°C and a 2 minute HCl etch at 1180°C. Using TSUPREM-4 simulations it was determined that the equivalent dose contribution of boron autodoping from H₂ bake dropped from 1x10¹³ cm⁻² for P#1 to 1.4x10¹² cm⁻² for P#2 by changing the H₂ bake temperature. A similar relationship between autodoping and temperature is illustrated in for processes without HCl etch using a 10 minute H₂ bake at temperatures of 1150 and 1080°C.

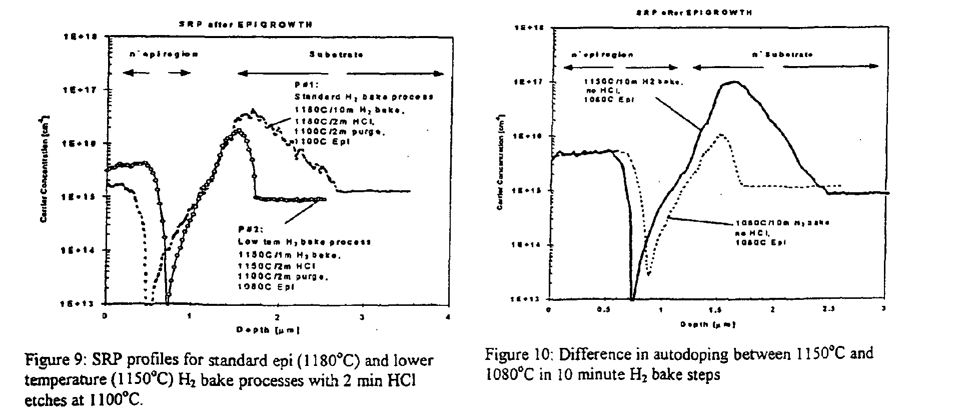

### 4.2 Effect of H₂ bake duration

Figure 11 shows how autodoping is affected by changing the H₂ bake time. The bake times of 2, 5 and 10 minutes were applied at 1080°C. The results indicate that autodoping increases significantly from 2 to 5 minutes and that it remains the same at 10 minutes. This suggests the possibility that at 1080°C, the susceptor and other internal reactor components become saturated with boron sometime between 2 and 5 minutes of H₂ bake time. Figure 12 shows us that autodoping did not saturate between 5 and 10 minutes of H₂ bake at the higher temperature of 1150°C, suggesting that the time required for boron saturation of the epi reactor increases as the H₂ bake temperature increases.

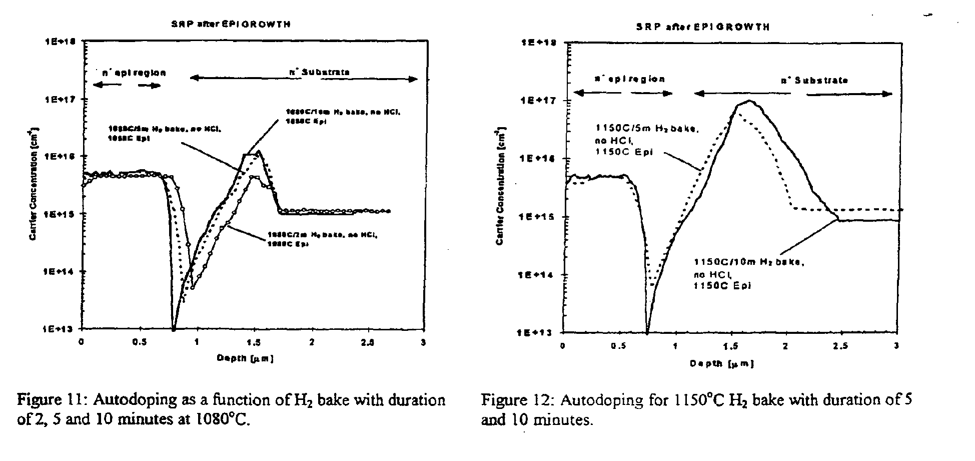

### 5. EPI PROCESS WITH ARSENIC DOPED N⁺ CAP

Although an intrinsic epi cap ^{3,4,5} layer is known to reduce autodoping, it cannot increase the NPN collector doping at the substrate-epi interface. Introduction of an N⁺ doped epi cap layer was proposed to: (1) counter-dope the boron autodopant; (2) elevate the doping level deep in the NPN collector. The As doped N⁺ cap is grown after the H₂ bake and optional HCl steps (if applicable), followed by an optional gas purge and by the final epi deposition. The temperature cycle diagram for a typical N⁺ cap epi process is show in Figure 13.

The goal is to reduce the boron autodoping peak concentration to less than 2-3x10¹⁵ cm⁻³ and increase the peak doping at the substrate/epi interface to 1-2x10¹⁶ cm⁻³. This peak must gradually decrease to within 0.5 µm of the desired epi concentration of 2-3x10¹³ cm⁻³. Figure 14 shows SRP profiles for the epi process on p⁻ substrate with (N#1) and without (P#3) N⁺ epi cap. The N⁺ epi cap process uses a 3 minute H₂ bake at 1080°C, followed by the deposition of a 0.3 µm N⁺ epi cap layer at 1080°C and 280 sccm flow of dopant gas. After an 8 minute purge at 900°C, the final epi was deposited with a thickness of 1.2 µm. The SRP for the standard epi process without cap layer shows an undesired n/p junction at the depth of 0.8 µm. This junction is a result of autodoping. The SRP (N#1) demonstrates the ability of N⁺ epi cap to compensate for the majority of autodoping. Although the n/p junction was no longer formed, this process did not meet the required doping levels that were defined earlier. Both the peak n-type concentration at the epi/substrate and the peak concentration of boron exceed the desired values. To improve the process, we experimented with different levels of N⁺ epi cap dopant flows and different purge temperatures. The results are shown in Figure 15. The SRP for process N#1 shown earlier in Figure 14 is used here for reference. overcompensate for the majority of the boron autodopant. The solution then is to introduce the As dopant earlier in the epi process.

### 6. INTRODUCTION OF ARSENIC DOPANT DURING H₂ BAKE CYCLE

### 6.1 N⁺ cap process

Using an As dopant during the H₂ bake cycle offers a logical solution to deficiencies in the N⁺ epi cap layer process. It enables one to introduce the compensating As species at the same time that the autodoping occurs. In Figure 16 the SRP profile labeled N#1 represents the N⁺ epi cap process described in the section above. The SRP curve B#1 shows a significant reduction in autodoping with compensation of boron dopant reaching deeper into the substrate. The process B#1 was created from process N#1 by adding 280 sscm of As dopant during the H₂ bake cycle. Unfortunately the reduction of autodoping occurred at the expense of significant increase of the doping concentration at the epi-substrate interface and in the collector region of the epi. Both of these doping peaks exceeded the limits defined in the previous section of this paper. The fact that the active epi concentration profile is not flat became another issue. The lightly doped n-type epitaxial region must have a nearly flat doping concentration from 2 to 3x10¹⁵ cm⁻³. Figure 17 compares the process B#1 with the optimized process B#2. The process B#2 uses a 2 minute H₂ bake with 220 sccm of As dopant gas, followed by an N⁺ doped epi cap layer, a 5 minute purge at 1080°C, an 8 minute purge at 850°C, and deposition of the active epi-layer. The dual gas purge process B#2 produces the correct doping level at the epi-substrate interface with a low level of autodoping, but fails to produce a flat doping concentration profile for the active epi 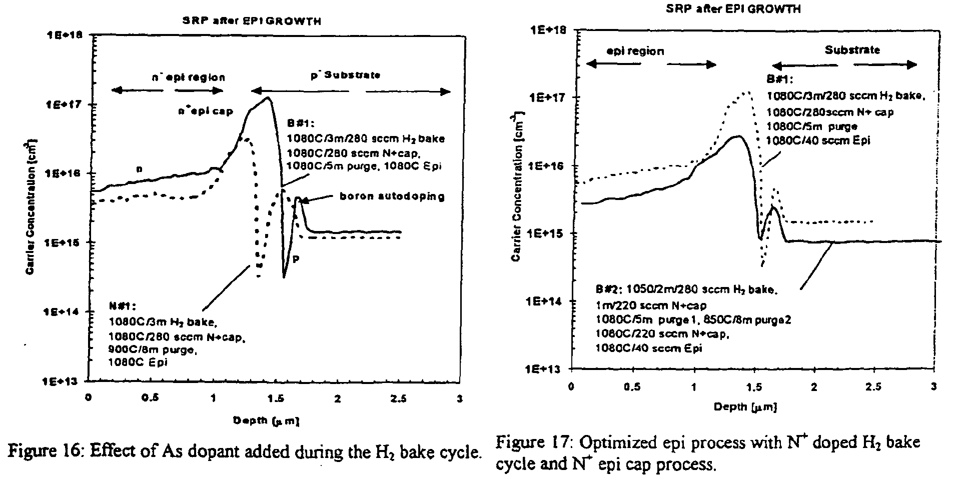 layer. Both, Figure 16 and Figure 17 prove the effectiveness of the As doped H₂ bake step in its ability to over-dope the boron autodopant at the epi-substrate interface. This suggests that the doping concentration peak at the interface can be reduced by removing the N⁺ dopant from the epi cap layer deposition step while still retaining the benefit of the autodopant reduction and elevation of the epi concentration at epi-substrate interface. The high temperature H₂ bake provides the arsenic dopant for overcompensation of the boron autodopant, and the intrinsic epi cap layer seals the silicon wafer and the reactor before depositing the final epitaxial layer.

The first attempt was to reduce the N⁺ peak concentration by reducing the As dopant flow to 180 sccm. This was used in the process N#3 with a 1 minutes N⁺ cap epi layer deposition at 1080°C, 180 sccm of the As dopant flow, followed by a 4.1 minute epi deposition cycle at 1080°C with 150 sccm of the dopant gas flow. The SRP results show this process has only minimal effect on epi autodoping, and that the n/p junction still forms in the active epi area. The next process N#2 used the highest flow of dopant, i.e. 300 sccm¹ combined with higher temperature purge at 1080°C, and all other conditions the same as for

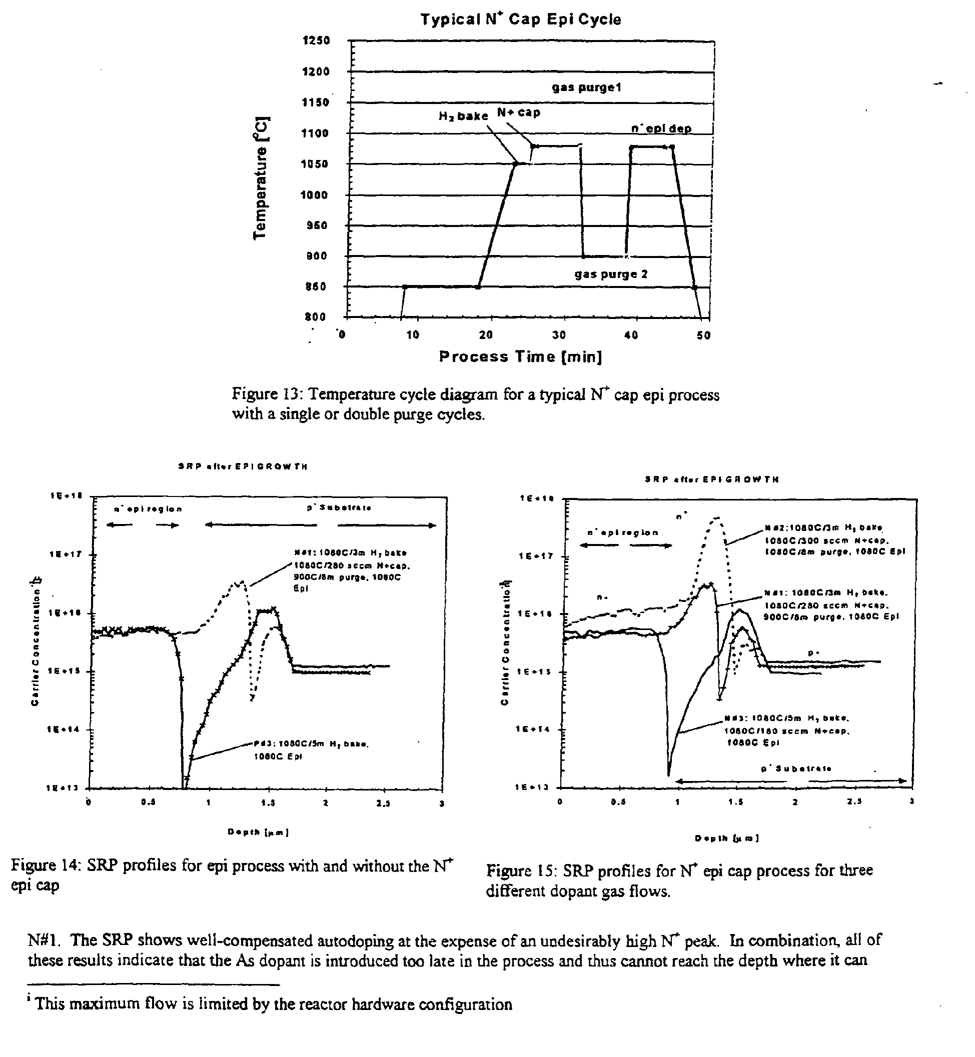

### 6.2 Single intrinsic cap process

Figure 19 shows the process temperature cycle for a typical single-layer intrinsic cap epi process employing a 2 minute 1050°C N⁺ doped H₂ bake cycle with 280 sccm flow of the dopant gas, followed by an intrinsic epi cap deposition at 1080°C. The cycle is completed with a gas purge at 850 or 1080°C, and active epi deposition at 1080°C. Figure 18 shows the SRP profiles for two intrinsic epi cap processes using single-gas purge cycles. The first process (I#1) uses a gas purge temperature of 850°C. The second process (I#2) uses a gas purge temperature of 1080°C. In both cases the gas purge is 10 minutes in duration. As expected for arsenic², increasing the temperature of the gas purge cycle (process I#2) decreases the peak n-type concentration at the epi-substrate interface and lowers the active epi concentration. Both the low and high temperature gas purge steps are ineffective at correcting the concentration profile slope in the active epi area.

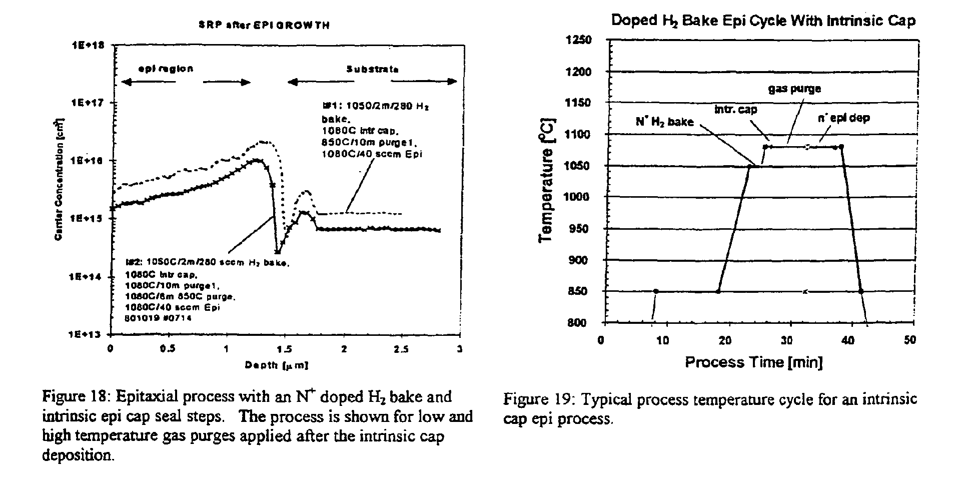

### 6.3 Dual intrinsic cap process

We experimented with a double intrinsic cap epi process to correct the doping profile deficiency in the active epi region. Figure 20 shows the temperature cycle for a dual intrinsic cap epi process. This process begins with a 2 minute 1050°C As doped H₂ bake cycle with 280 sccm of the dopant gas, followed by a deposition of the first intrinsic cap layer at 1080°C to seal both the boron autodopant and the arsenic dopant that are introduced during the H₂ bake cycle. Next, a 10 minute gas purge is applied at 1080°C. This process step was designed to reduce the arsenic concentration in the deposition chamber of the epi reactor. The second intrinsic cap is then deposited at 1080°C to achieve a sharp transition from doping concentration of 1-2x10¹⁶ cm⁻³ at the epi-substrate interface to the desired active epi doping concentration of 1-2x10¹⁵ cm⁻³. Figure 21 compares doping profiles of the three basic epi process cycles. All cycles employ the same arsenic-doped H₂ bake cycle to suppress the autodoping effect. The first process (B#2) uses an N⁺ cap and dual gas purge epi cycle (see Figure 13). This process was able to suppress the autodoping, but incurred the penalty of achieving a very poor doping profile control within the n-epi layer. The next process (I#2) uses a single intrinsic cap layer at 1080°C to seal the substrate before active epi deposition (see Figure 19). The process I#2 improved the suppression of boron autodoping and lowered the concentration of the dopant within the active epi region. The doping profile is still not flat and is similar to one from process B#2. The dual intrinsic cap process (DI) offers the best autodopant suppression and produces a flat doping profile within the active epi region. 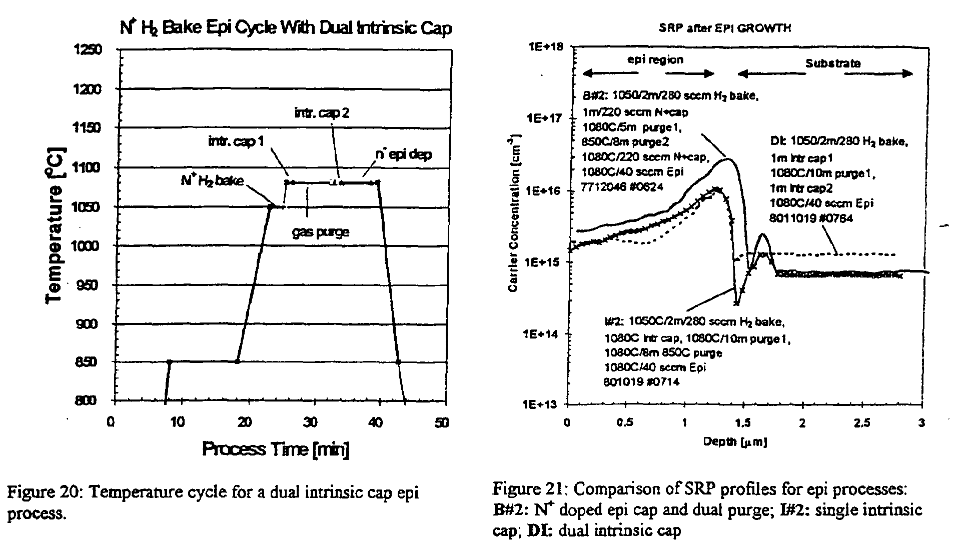 It is known that autodoping varies across the direction of the gas stream¹. It is also dependent on temperature. The boron autodoping increases with temperature, while the arsenic autodoping decreases with temperature². For the present process, which uses the arsenic doped H₂ bake step and has the boron dopant supplied by the autodoping mechanism, both arsenic and boron dopants are present at the same time in the deposition cycle. These two dopants have exactly the opposite temperature doping incorporation dependency. In the batch epi reactors, the zone temperatures are often adjusted to compensate for the gas flow pattern. This emphasizes the importance of knowing how the differencies in zone temperatures affect the process uniformity across the zones in the batch epi reactor. In Figure 22, the studies of these dependencies are shown as SRP profiles from the N⁺ doped H₂ bake cycle process for the top (TP), middle (MD) and bottom (BT) rows of the AMAT 7810 epi reactor. In this particular epi reactor, the top row zone was running slightly hotter than the zones for the middle and bottom susceptor rows. The effect of difference in zone temperature is clearly visible in Figure 22. The SRP profile from the wafer deposited in the top row (TP) shows a higher autodoping concentration than wafers BT and MD. Such results are expected given that the arsenic incorporation decreases with temperature and that the boron evaporation (and thus the autodoping) increases with temperature.

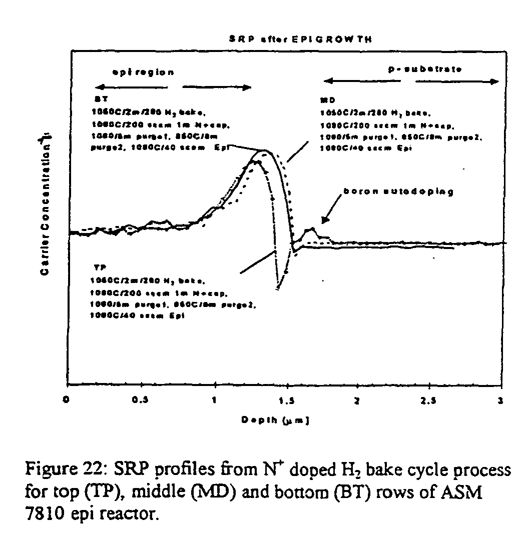

### 7. CONCLUSIONS

Different N⁺ doped and intrinsic epi cap layers in conjunction with introduction of the arsenic dopant during the high temperature H₂ bake cycle were evaluated for its effectiveness in supression of autodoping and elevation of the n-type doping level at the epi-substrate interface. An epitaxial technique, which introduces As dopant during the high temperature H₂ bake, combined with use of dual intrinsic epi cap layer was found the most effective in controlling both, the autodoping and the overall doping profile of the epi layer. This dual cap technique has proven very effective in suppressing the effects of boron autodoping and correcting the NPN collector profile.

### 8. ACKNOWLEDGEMENT

The authors are indebted to Kevin Lanoue for careful review of the manuscript. They would also like to thank Derek Robinson, Pam Mayernik, and Pete Rathfelder for their numerous suggestions and project support.

### 9. REFERENCIES

¹ G.R. Shrinivasan, "Autodoping Effects in Silicon Epitaxy", J. Electrochem. Soc., 127, pp. 1334-1342, 1980.
² H.R. Chang, "Autodoping in Silicon Epitaxy", J. Electrochem. Soc., 132, pp. 219-224, 1986
³ Rick L. Wise., "Method of Forming Thin Epitaxial Layers Using Multistep Growth for Autodoping Control", United States Patent 4,859,626, August 1989
⁴ M. El-Diwany, J. Borland, J. Chen, S. Hu, P.V. Wijnen, C. Vorst, V. Akylas, M. Brassington and R. Rauzuk, "An Advanced BiCMOS Process Utilizing Ultra-Thin Silicon Epitaxy Over Arsenic Buried Layers", IEDM 1989 Proceedings, Washington, D.C. pp. 245-248.
⁵ M. Tabe and H. Nakamura, "Adsorbed Layer Model for Autodoping Mechanism in Silicon Epitaxial Growth", J. Electrochem. Soc., 126, pp. 822-826, 1979

## Claims

1. A method of making an epitaxial layer on a silicon substrate (30) having in a major surface thereof a P+ field layer region in a substantial portion of the major surface, comprising:
(a) loading (1) the substrate in a reactor and providing a carrier gas therein;
(b) performing (4) a low temperature bake cycle on the substrate at a first temperature
(c) further heating (5) the substrate to a second temperature while providing N+ dopant gas in the carrier gas;
(d) performing (6) a high temperature bake cycle on the substrate in the presence of N+ dopant gas;
(e) depositing (7) a first intrinsic epitaxial cap layer (36) on the substrate (30);
(f) performing (8) a first high temperature gas purge cycle;
(g) depositing (9) a second intrinsic epitaxial cap layer (37) on the first intrinsic epitaxial cap layer; and
(h) depositing (11) an N- epitaxial layer (38) having a thickness substantially greater than the thickness of either of the first and.second intrinsic cap layers on the second intrinsic epitaxial cap layer (37).

2. The method of Claim 1 wherein the first temperature is approximately 850°C and step (c) includes ramping the temperature of the substrate up to approximately 1050°C.

3. The method of Claim 1 wherein step (e) includes depositing the first intrinsic epitaxial cap layer (36) with a thickness of approximately 0.3 µm.

4. The method of Claim 3 wherein step (g) includes depositing the second intrinsic epitaxial cap layer (37) with a thickness of approximately 0.3 µm.

5. The method of Claim 4 wherein step (h) includes depositing the N- epitaxial layer with a thickness of approximately 0.9 µm.

6. The method of Claim including performing an N type ion implantation in the N-epitaxial layer to increase the conductivity thereof, the implantation dopant concentration causing reduction of a dip in the N type dopant concentration in the N- epitaxial layer (38) at a depth beyond the implant depth, the method including providing the N+ dopant gas in steps (c) and (d) in sufficient amounts to provide enough N type dopant ions to create a graded increase in the first and second.intrinsic epitaxial cap layers and the N-epitaxial layer (38) to at least partially compensate the dip.

7. The method of Claim 1 including performing (10) a second high temperature gas purge after step (g), wherein the temperature of the first high temperature gas purge cycle is higher than the temperature of the second high temperature gas purge cycle.

8. The method of Claim 1 including performing a second high temperature bake cycle at a temperature approximately equal to the second temperature between steps (g) and (h).

9. The method of claim 1, wherein the silicon substrate (30) further comprises a plurality of P+ buried layer regions and a plurality of N+ layer regions.

10. A semiconductor structure (30), comprising:
a substrate having a major surface;
a plurality of doped regions (31, 32, 33, 34) in the substrate at the major surface; and
a first intrinsicly-formed epitaxial cap layer (36) on the major surface,
**characterised in that** the structure (30) further comprises a second intrinsicly-formed epitaxial cap layer (37) on the first intrinsicly-formed epitaxial cap layer (36) and an N-type epitaxial layer (38) on the second intrinsicly-formed epitaxial cap layer (37).

11. The semiconductor structure (30) according to claim 10, wherein a graded N type dopant is in the first and second intrinsicly-formed epitaxial cap layers (36, 37).

12. The semiconductor structure (30) according to claim 10 or claim 11, wherein a graded N type dopant is in the N type epitaxial layer (38) for compensating a dip in N type dopant concentration of an N type implant in the N type epitaxial layer (38).

13. The semiconductor structure (30) according to any one of claims 10 to 12, wherein the plurality of doped regions (31, 32, 33, 34) includes P+ layers that cumulatively cover more than half of the major surface.

## Patentansprüche

1. Verfahren zum Herstellen einer Epitaxieschicht auf einem Siliciumsubstrat (30), das in einer Hauptoberfläche davon in einem wesentlichen Abschnitt der Hauptoberfläche ein P⁺-Feldschichtgebiet aufweist, wobei das Verfahren umfasst:
(a) Laden (1) des Substrats in eine Reaktionskammer und Bereitstellen eines Trägergases darin;
(b) Ausführen (4) eines Niedertemperatur-Einbrennzyklus an dem Substrat bei einer ersten Temperatur;
(c) weiteres Erwärmen (5) des Substrats auf eine zweite Temperatur, während in dem Trägergas ein N⁺-Dotierungsgas bereitgestellt wird;
(d) Ausführen (6) eines Hochtemperatur-Einbrennzyklus an dem Substrat in Anwesenheit des N⁺-Dotierungsgases;
(e) Ablagern (7) einer ersten intrinsischen Epitaxiedeckschicht (36) auf dem Substrat (30);
(f) Ausführen (8) eines ersten Hochtemperatur-Gasspülzyklus;
(g) Ablagern (9) einer zweiten intrinsischen Epitaxiedeckschicht (37) auf der ersten intrinsischen Epitaxiedeckschicht; und
(h) Ablagern (11) einer N⁻-Epitaxieschicht (38) mit einer Dicke, die wesentlich größer als die Dicke entweder der ersten oder der zweiten intrinsichen Deckschicht auf der zweiten intrinsischen Epitaxiedeckschicht (37) ist.

2. Verfahren nach Anspruch 1, bei dem die erste Temperatur näherungsweise 850 °C beträgt und bei dem der Schritt (c) das Hochfahren der Temperatur des Substrats bis auf näherungsweise 1050 °C enthält.

3. Verfahren nach Anspruch 1, bei dem der Schritt (e) das Ablagern der ersten intrinsischen Epitaxiedeckschicht (36) mit einer Dicke von näherungsweise 0,3 µm enthält.

4. Verfahren nach Anspruch 3, bei dem der Schritt (g) das Ablagern der zweiten intrinsischen Epitaxiedeckschicht (37) mit einer Dicke von näherungsweise 0,3 µm enthält.

5. Verfahren nach Anspruch 4, bei dem der Schritt (h) das Ablagern der N⁻-Epitaxieschicht mit einer Dicke von näherungsweise 0,9 µm enthält.

6. Verfahren nach Anspruch 1, das das Ausführen einer N-Ionenimplantation in der N⁻-Epitaxieschicht enthält, um deren Leitfähigkeit zu erhöhen, wobei die Implantationsdotierungskonzentration eine Verringerung einer Einsattelung in der N-Dotierungskonzentration in der N⁻-Epitaxieschicht (38) in einer Tiefe jenseits der Implantationstiefe veranlasst, wobei das Verfahren das Bereitstellen des N⁺-Dotierungsgases in den Schritten (c) und (d) in ausreichenden Mengen enthält, um genug N-Dotierungsionen bereitzustellen, um in der ersten und in der zweiten intrinsischen Epitaxiedeckschicht und in der NEpitaxieschicht (38) eine allmähliche Zunahme zu erzeugen, um die Einsattelung wenigstens teilweise zu kompensieren.

7. Verfahren nach Anspruch 1, das das Ausführen (10) einer zweiten Hochtemperatur-Gasspülung nach dem Schritt (g) enthält, wobei die Temperatur des ersten Hochtemperatur-Gasspülzyklus höher als die Temperatur des zweiten Hochtemperatur-Gasspülzyklus ist.

8. Verfahren nach Anspruch 1, das zwischen den Schritten (g) und (h) das Ausführen eines zweiten Hochtemperatur-Einbrennzyklus bei einer Temperatur, die näherungsweise gleich der zweiten Temperatur ist, enthält.

9. Verfahren nach Anspruch 1, bei dem das Siliciumsubstrat (30) ferner mehrere vergrabene P⁺-Schichtgebiete und mehrere N⁺-Schichtgebiete umfasst.

10. Halbleiterstruktur (30), die umfasst:
ein Substrat mit einer Hauptoberfläche;
mehrere dotierte Gebiete (31, 32, 33, 34) in dem Substrat an der Hauptoberfläche; und
eine erste intrinsisch ausgebildete Epitaxiedeckschicht (36) auf der Hauptoberfläche, **dadurch gekennzeichnet, dass** die Struktur (30) ferner eine zweite intrinsisch ausgebildete Epitaxiedeckschicht (37) auf der ersten intrinsisch ausgebildeten Epitaxiedeckschicht (36) und eine N-Epitaxieschicht (38) auf der zweiten intrinsisch ausgebildeten Epitaxiedeckschicht (37) umfasst.

11. Halbleiterstruktur (30) nach Anspruch 10, bei der sich in der ersten und in der zweiten intrinsisch ausgebildeten Epitaxiedeckschicht (36, 37) ein abgestuftes N-Dotierungsmittel befindet.

12. Halbleiterstruktur (30) nach Anspruch 10 oder Anspruch 11, bei dem sich in der N-Epitaxieschicht (38) ein abgestuftes N-Dotierungsmittel befindet, um eine Einsattelung der N-Dotierungskonzentration einer N-Implantation in der N-Epitaxieschicht (38) zu kompensieren.

13. Halbleiterstruktur (30) nach einem der Ansprüche 10 bis 12, bei der die mehreren dotierten Gebiete (31, 32, 33, 34) P⁺-Schichten enthalten, die mehr als die Hälfte der Hauptoberfläche kumulativ bedecken.

## Revendications

1. Procédé de réalisation d'une couche épitaxiale sur un substrat de silicium (30) présentant sur une surface principale de celle-ci une région de couche de champ P+ dans une grande partie de la surface principale, comprenant :
(a) le chargement (1) du substrat dans un réacteur et la fourniture d'un gaz porteur à l'intérieur ;
(b) l'exécution (4) d'un cycle de cuisson à basse température sur le substrat à une première température ;
(c) la poursuite du chauffage (5) du substrat à une seconde température tout en fournissant un gaz dopant N+ dans le gaz porteur ;
(d) l'exécution (6) d'un cycle de cuisson à haute température sur le substrat en présence du gaz dopant N+ ;
(e) le dépôt (7) d'une première couche d'encapsulation épitaxiale intrinsèque (36) sur le substrat (30) ;
(f) l'exécution (8) d'un premier cycle d'évacuation du gaz à haute température ;
(g) le dépôt (9) d'une seconde couche d'encapsulation épitaxiale intrinsèque (37) sur la première couche d'encapsulation épitaxiale intrinsèque ; et
(h) le dépôt (11) d'une couche épitaxiale N- (38) qui présente une épaisseur sensiblement supérieure à l'épaisseur de l'une ou l'autre des première et seconde couches d'encapsulation intrinsèques sur la seconde couche d'encapsulation épitaxiale intrinsèque (37).

2. Procédé selon la revendication 1, dans lequel la première température est égale à 850 °C environ et l'étape (c) inclut la montée progressive de la température du substrat jusqu'à 1050 °C environ.

3. Procédé selon la revendication 1, dans lequel l'étape (e) inclut le dépôt de la première couche d'encapsulation épitaxiale intrinsèque (36) avec une épaisseur de 0,3 µm environ.

4. Procédé selon la revendication 3, dans lequel l'étape (g) inclut le dépôt de la seconde couche d'encapsulation épitaxiale intrinsèque (37) avec une épaisseur de 0,3 µm environ.

5. Procédé selon la revendication 4, dans lequel l'étape (h) inclut le dépôt de la couche épitaxiale N- avec une épaisseur de 0,9 µm environ.

6. Procédé selon la revendication 1, comprenant l'exécution d'une implantation ionique de type N dans la couche épitaxiale N- de manière à accroître sa conductivité, la concentration en dopant d'implantation provoquant une réduction de l'immersion dans la concentration en dopant de type N dans la couche épitaxiale N- (38) à une profondeur au-delà de la profondeur d'implantation, le procédé comprenant la fourniture du gaz dopant N+ dans les étapes (c) et (d) en quantités suffisantes pour fournir suffisamment d'ions dopants de type N de manière à créer une augmentation progressive des première et seconde couches d'encapsulation épitaxiales intrinsèques et de la couche épitaxiale N- (38) afin de compenser au moins en partie l'immersion.

7. Procédé selon la revendication 1, comprenant l'exécution (10) d'une seconde évacuation du gaz à haute température après l'étape (g), dans laquelle la température du premier cycle d'évacuation du gaz à haute température est supérieure à la température du second cycle d'évacuation du gaz à haute température.

8. Procédé selon la revendication 1, comprenant l'exécution d'un second cycle de cuisson à haute température à une température approximativement égale à la seconde température entre les étapes (g) et (h).

9. Procédé selon la revendication 1, dans lequel le substrat de silicium (30) comprend en outre une pluralité de régions de couche enterrée P+ et une pluralité de régions de couche N+.

10. Structure de semi-conducteur (30), comprenant :
un substrat qui présente une surface principale ;
une pluralité de régions dopées (31, 32, 33, 34) dans le substrat au niveau de la surface principale ; et
une première couche d'encapsulation épitaxiale formée de manière intrinsèque (36) sur la surface principale,
**caractérisée en ce que** la structure (30) comprend en outre une seconde couche d'encapsulation épitaxiale formée de manière intrinsèque (37) sur la première couche d'encapsulation épitaxiale formée de manière intrinsèque (36), et une couche épitaxiale de type N (38) sur la seconde couche d'encapsulation épitaxiale formée de manière intrinsèque (37).

11. Structure de semi-conducteur (30) selon la revendication 10, dans laquelle un dopant progressif de type N se trouve dans les première et seconde couches d'encapsulation épitaxiales formées de manière intrinsèque (36, 37).

12. Structure de semi-conducteur (30) selon la revendication 10 ou la revendication 11, dans laquelle un dopant progressif de type N se trouve dans la couche épitaxiale de type N (38) de manière à compenser une immersion dans une concentration de dopant de type N d'une implantation de type N dans la couche épitaxiale de type N (38).

13. Structure de semi-conducteur (30) selon l'une quelconque des revendications 10 à 12, dans laquelle la pluralité de régions dopées (31, 32, 33, 34) inclut des couches P+ qui couvrent de manière cumulative plus de la moitié de la surface principale.
